# EUROPÄISCHE PATENTSCHRIFT

(11) **EP 3 309 967 B1**
(45) Veröffentlichungstag und Bekanntmachung des Hinweises auf die Patenterteilung: **03.03.2021**
(21) Anmeldenummer: 17195858.0
(22) Anmeldetag: 11.10.2017
(51) Int. Cl.: H03K 17/975

(54) **KAPAZITIVE SCHALT-VORRICHTUNG**
CAPACITIVE SWITCHING DEVICE
DISPOSITIF DE COMMUTATION CAPACITIF

(30) Priorität: 17.10.2016 EP 16194076
(43) Veröffentlichungstag der Anmeldung: 18.04.2018
(73) Patentinhaber: RAFI GmbH & Co. KG, 88276 Berg (DE)
(72) Erfinder: Fleischer, Frank, 88368 Bergatreute (DE)
(74) Vertreter: Engelhardt, Volker

(56) Entgegenhaltungen:
- WO-A1-2013/177322
- US-A1- 2011 057 899
- US-A1- 2012 008 266
- US-A1- 2016 026 318

## Beschreibung

Die Erfindung bezieht sich auf eine kapazitive Schalt-Vorrichtung zur Umwandlung einer manuellen oder mechanischen Zustellbewegung in ein elektrisches Signal, durch das ein elektrisches Gerät gesteuert ist, nach dem Oberbegriff des Patentanspruches 1.

Aus der WO 2016/016612 A1 kann eine derartige Schalt-Vorrichtung entnommen werden, die zum einem manuelle oder mechanische Zustellbewegungen in entsprechende elektrische Schaltsignale umwandeln kann und die zum anderen auch eine axiale Bewegung des Touchscreen und des Display ermöglicht und diese axiale Bewegung erfasst. Zur Auswertung dieser Bewegung ist umlaufend neben dem Touchscreen und den diese abdeckende Abdeckplatte eine Sensor-Anordnung vorgesehen, die im Wesentlichen aus drei unterschiedlich betriebenen Sensorenelementen besteht. Dabei ist das erste Sensorelement fest mit dem Gehäuse verbunden und dient zur Erzeugung eines elektrischen Feldes. Das erste Sensorelement ist somit elektrisch leitfähig. Das zweite Sensorelement liegt fluchtend oberhalb des ersten Sensorselementes und besteht aus einem elektrisch leitfähigen Werkstoff. Um das von dem ersten Sensorelement erzeugte elektrische Feld nach außen abzuschirmen, ist ein drittes Sensorelement zwischen dem zweiten Sensorelement und der Abdeckplatte anzubringen, so dass das erste und zweite Sensorelement nach außen kapazitiv isoliert sind.

Sobald eine Betätigungskraft auf die Abdeckplatte, den Touchscreen und das Display einwirkt, bewegt sich diese Baueinheit in das Innere des Gehäuses, wodurch der Abstand zwischen dem ersten und dem zweiten Sensorelement reduziert ist, so dass dadurch eine Veränderung des elektrischen Feldes feststellbar ist, die durch eine Auswerteelektronik erfasst ist und in entsprechende elektrische Schaltsignale umgewandelt werden kann. Beispielsweise kann eine solche Sensor-Anordnung dazu verwendet werden, dass der Touchscreen und das Display durch die aufzubringende Betätigungskraft freigeschaltet werden, um erst anschließend überhaupt die Schaltflächen des Touchscreens bedienen zu können.

Die Sensor-Anordnung aus drei unterschiedlichen Sensorelementen ist in nachteiliger Weise bezüglich ihrer Herstellung kostenintensiv und die Ausrichtung der Sensorelemente zueinander ist zeitaufwändig.

Darüber hinaus offenbaren die Druckschriften US 2016/026318 A1, US 2011/057899 A1 sowie US 2012/08266 A1 eine Schalt-Vorrichtung der eingangs genannten Art. Die als Baueinheiten ausgebildeten Abdeckplatten und Displays sind im Inneren eines Gehäuses angeordnet und seitlich mittels eines elektrisch leitfähigen Schirmes gekapselt. Im Inneren des rechteckförmigen ausgestalteten Schirmes ist ein Sensor vorgesehen, dessen elektrisches Feld im Inneren des Schirmes verläuft und mittels einer elektrischen Auswerteelektronik oder Controller überwacht ist.

Als nachteilig hat sich bei diesem Stand der Technik herausgestellt, dass eine Beeinflussung des elektrischen Feldes im Inneren des Schirmes beim Betätigen der Abdeckplatte aufgrund der mechanischen Zustellbewegungen nicht erreicht ist, sondern vielmehr ausschließlich durch die elektrische Auswerteelektronik erfassbar ist. Folglich dienen die randseitig verbauten Sensoren nicht zur Freischaltung des elektrischen Gerätes bzw. des Displays, sondern erkennen allenfalls, dass eine Betätigungskraft auf die Abdeckplatte im Bereich des Schirmes einwirkt, denn der den Sensor ummantelnde Schirm ist aus einem formstabilen Werkstoff gefertigt und demnach elastisch nicht verformbar.

Es ist daher Aufgabe der Erfindung, eine Schalt-Vorrichtung der eingangs genannten Gattung derart weiterzubilden, dass unter Beibehaltung der Funktionsweise der Schaltvorrichtung eine einfache und kostensparende Herstellung und Montage der Schaltvorrichtung mit einer geeigneten Sensor-Anordnung zur Verfügung gestellt ist.

Die Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass zwischen dem Gehäuse und der Abdeckplatte mindestens ein kapazitiv betriebener Sensor vorgesehen ist, und dass zwischen dem Sensor und der Abdeckplatte ein Schirm aus einem elektrisch leitfähigen Werkstoff angeordnet ist, durch den der Sensor nach außen kapazitiv isoliert ist und der mit dem Sensor ein gemeinsames elektrisches Feld erzeugt, ist erreicht, dass die Montage der erfindungsgemäßen Schaltvorrichtung schnell und unkompliziert vorgenommen werden kann. Der Schirm kann als äußere Hülle einer Dichtung ausgestaltet sein, die den Sensor trägt.

Die Abschirmung des elektrischen Feldes zwischen dem Sensor und Schirm wird ausschließlich von dem Schirm erreicht, der den Sensor, wenn dieser beispielsweise an einer Dichtung freischwingend befestigt ist, ganz ummantelt.

Da der kapazitiv betriebene Sensor in der Dichtung angebracht ist, bewegt sich dieser sowohl relativ zu dem Gehäuse als auch zu der Abdeckplatte, sobald diese betätigt ist. Aufgrund der Distanzveränderungen zwischen dem Sensor und dem Schirm verändert sich das dazwischen verlaufende elektrische Feld, so dass ein elektrisches Signal generierbar ist, das in Abhängigkeit von der Änderung des elektrischen Feldes steht. Der den Sensor und die Dichtung umschließende oder ummantelnde Körper ist als Schirm ausgestaltet und schirmt demnach den Sensor und das elektrische Feld nach außen, wodurch störende Einflüsse der Umgebung vermieden sind.

Des Weiteren können innerhalb des Schirmes Dichtungselemente oder dgl. vorgesehen sein, um die elektrischen Bauteile im Inneren des Gehäuses vor Feuchtigkeit und anderen Schmutzeintritten von außen zu schützen. Es ist Voraussetzung, dass sowohl der Schirm als auch die Dichtungsmittel elastisch verformbar sind, um die axialen Bewegungen der Abdeckplatte freizugeben. Gleichzeitig dienen die Dichtungen und der Schirm bei Betätigung als Kraftreservoir für die Rückstellung, sobald eine Betätigungskraft auf die Abdeckplatte nicht länger vorliegt.

In der Zeichnung sind sechs Ausführungsbeispiele einer Schaltvorrichtung dargestellt, die nachfolgend näher erläutert sind. Im Einzelnen zeigt:
- Figur 1: eine Schaltvorrichtung, die aus einem Gehäuse besteht, in das eine Aufnahmeöffnung eingearbeitet ist und aus einem Touchscreen, der von einer Abdeckplatte nach außen verschlossen ist, die jeweils in der Durchgangsöffnung axial beweglich gelagert sind, in Draufsicht,
- Figur 2a: zwei unterschiedlich ausgestaltete Schaltvorrichtungen gemäß Figur 1, im Schnitt,
- Figur 2b: eine vergrößerte Darstellung der Schaltvorrichtung gemäß Figur 2a, im unbetätigten Zustand,
- Figur 2c: eine vergrößerte Darstellung der Schaltvorrichtung gemäß Figur 2a, im betätigten Zustand,
- Figur 3a: zwei erfindungsgemäße Ausführungsvarianten der Schaltvorrichtung gemäß Figur 1,
- Figur 3b: eine vergrößerte Darstellung der Schaltvorrichtung gemäß Figur 3a, im unbetätigten Zustand,
- Figur 3c: eine vergrößerte Darstellung der Schaltvorrichtung gemäß 3a, im betätigten Zustand.
- Figur 4a: ein fünftes und sechstes Ausführungsbeispiel der Schaltvorrichtung gemäß Figur 1,
- Figur 4b: eine vergrößerte Darstellung der Schaltvorrichtung gemäß Figur 4a mit einem bestromten Dichtungs-Schirm, der einen runden Querschnitt aufweist, im unbetätigtem Zustand,
- Figur 4c: die Schaltvorrichtung gemäß Figur 4b im betätigtem Zustand
- Figur 4d: die Schaltvorrichtung gemäß Figur 4a in vergrößerter Darstellung mit zwei Sensorflächen und im einem dazu benachbart angeordnetem Dichtungs-Schirm in unbetätigtem Zustand und
- Figur 4e: die Schaltvorrichtung gemäß Figur 4d im betätigtem Zustand.

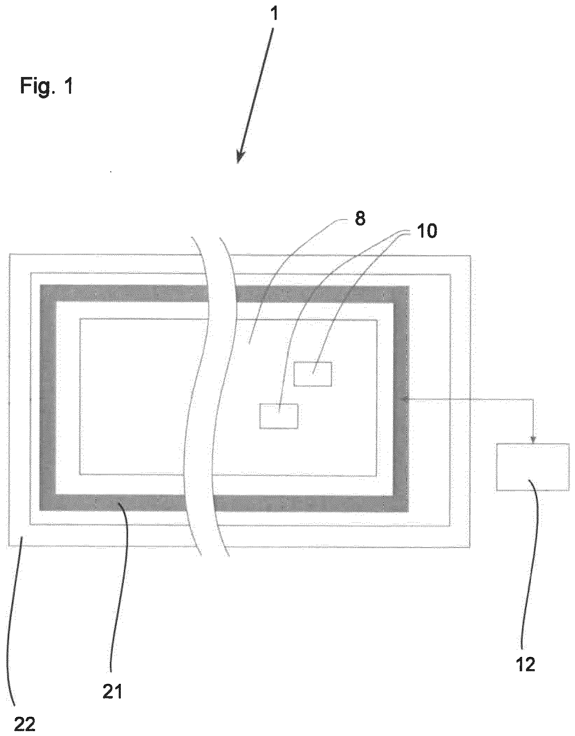

Aus Figur 1 ist eine Schaltvorrichtung 1 zu entnehmen, die aus einem Gehäuse 4 gebildet ist. In das Gehäuse 4 ist eine rechteckförmige Aufnahmeöffnung 5 eingearbeitet, in die ein Touchscreen 6 axial beweglich eingesetzt ist. Der Touchscreen 6 ist nach außen mittels einer Abdeckplatte 7, die beispielsweise aus Glas oder einem biegefesten Kunststoffmaterial hergestellt ist, abgeschirmt. Im Inneren des Gehäuses 4 ist dem Touchscreen 6 ein Display 8 zugeordnet, so dass durch das Display 8 und den Touchscreen 6 eine Vielzahl von Schaltflächen 10 gebildet sind, die beispielsweise von einem menschlichen Finger berührt werden können und somit ein Schaltsignal ausgelöst werden kann. Die jeweiligen Schaltflächen 10 sind elektrisch mit einer Auswerteelektronik 12 gekoppelt, durch die dann anschließend ein elektrisches Gerät, beispielsweise ein Smartphone, eine Werkzeugmaschine oder dgl., betrieben werden kann.

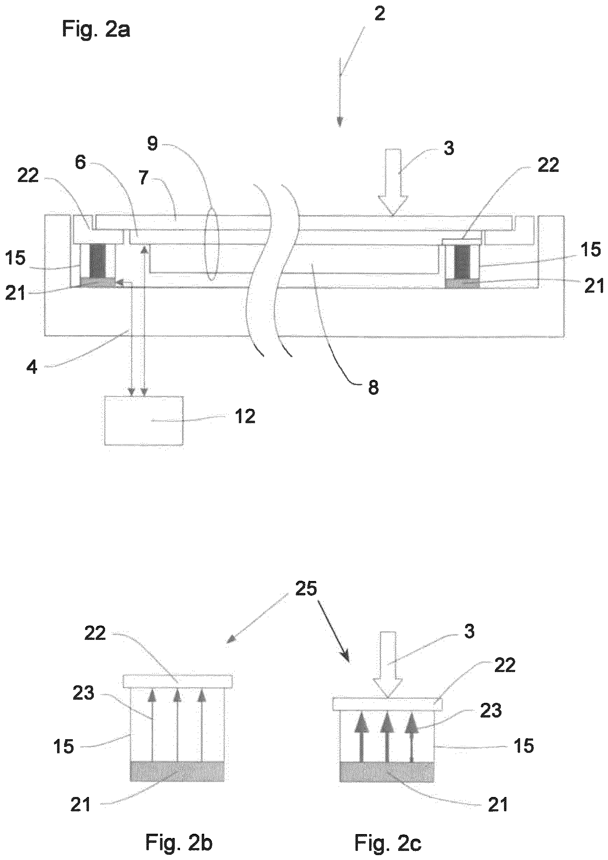

Aus Figur 2a ist ersichtlich, dass die Abdeckplatte 7, der Touchscreen 6 und das Display 8 eine gemeinsame Baueinheit 9 bilden, die beispielsweise durch eine Betätigungskraft 3 in eine axiale Zustellbewegung 2 überführt werden kann. Um die Schaltflächen 10 freizuschalten, ist daher zunächst die Baueinheit 9 axial zu betätigen, um den Einschaltvorgang für die Schaltflächen 10 freizugeben.

In der linken Seite des Gehäuses 4 ist dabei an diesem ein kapazitiv betriebener Sensor 21 angebracht, der demnach ortsfest und als eine Art Rahmen umlaufend um das gesamte Gehäuse im Randbereich der Aufnahmeöffnung 5 angeordnet ist. Auf dem Sensor 21 ist eine Dichtung 15 vorgesehen, die aus einem elastisch verformbaren Werkstoff hergestellt ist und eventuell ein zusätzliches Federelement, welches für die Rückstellung sorgt. Zwischen der Dichtung 15 und der Abdeckplatte 7 ist ein Schirm 22 vorgesehen, der nach Art eines umlaufenden Rahmens zwischen der Abdeckplatte 7 und dem Gehäuse 4 angeordnet ist. Durch den Schirm 22 sollen störende elektrische oder magnetische Einflüsse von außen abgeschirmt sein, so dass ausschließlich das von dem kapazitiv betriebenen Sensor 21 erzeugte Feld zwischen diesem und dem Schirm 22 verläuft.

Auf der rechten Seite des Gehäuses 4 gemäß Figur 2a ist der Schirm 22 als im Querschnitt L-förmiges Bauteil ausgestaltet, das unmittelbar in den Touchscreen 6 oder wahlweise auch in die Abdeckplatte 7 eingesetzt und in diesen ortsfest gehalten sind.

Den Figuren 2b und 2c ist die Veränderung des elektrischen Feldes 23 zwischen dem Sensor 21 und dem Schirm 22 zu entnehmen, sobald auf die Abdeckplatte 7 die Betätigungskraft 3 einwirkt und folglich die Baueinheit 9 die Zustellbewegung 2 vollzieht, wodurch sich der Abstand zwischen dem Sensor 21 und dem Schirm 22 entsprechend verändert. Durch diese Distanzveränderung zwischen dem Sensor 21 und dem Schirm 22 entsteht eine Änderung des elektrischen Feldes 2,3, die von der Auswerteelektronik 12 erfasst und demnach in ein elektrisches Signal umgewandelt werden kann.

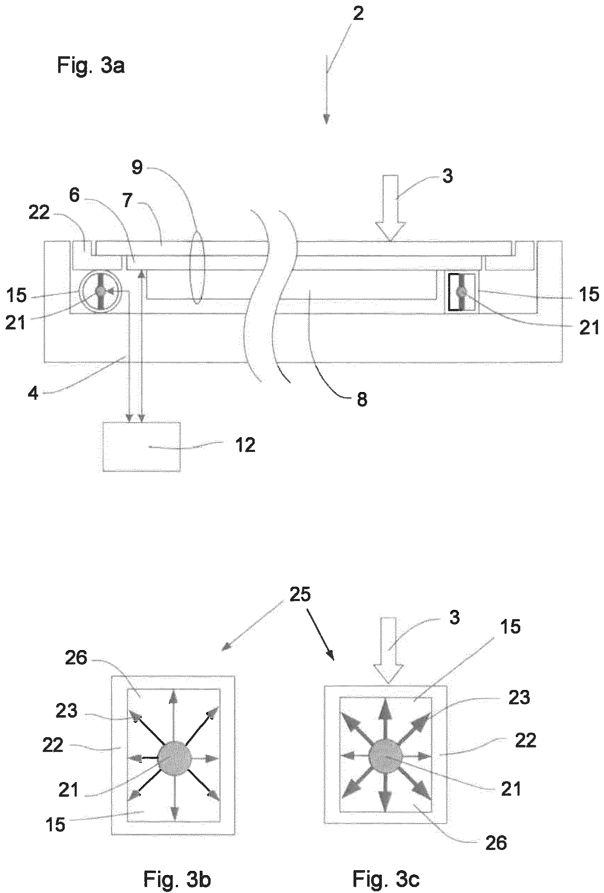

Der Figur 3a ist zu entnehmen, dass der Schirm 22 gemäß der linken Seite des Gehäuses 4 als vollständig geschlossener Zylinder oder und Kegel gemäß der rechten Seite des Gehäuses 4 als rechteckförmiger Körper ausgestaltet sein kann und die Funktion einer Dichtung übernimmt. Darüber hinaus ist der Sensor 21 unmittelbar an der Dichtung 15 im Inneren des Schirms 22 angebracht, so dass bei Betätigung eine schwingende Bewegung des Sensors 21 bezogen auf das Gehäuse 4 und der Baueinheit 9 entsteht. Das elektrische Feld 23 wird demnach von dem Sensor 21 nach außen abgestrahlt und von der Innenwand des zylinder- oder rechteckförmigen Schirmes 22 aufgenommen.

Sobald die Baueinheit 9 durch die Betätigungskraft 3 in die Aufnahmeöffnung 5 des Gehäuses 4 eingedrückt ist, verändert sich die Querschnittsform des jeweiligen dreidimensionalen Schirmes 22 derart, dass der Abstand zwischen dem zentrisch angeordneten Sensor 21 und der Innenwand des jeweiligen Schirmes 22 verändert ist, wodurch das elektrische Feld 23 eine andersartige Charakteristik aufweist, die von der Auswerteelektronik 12 messbar und in entsprechende Steuersignale umwandelbar ist. Der dreidimensionale Schirm 22 besteht aus einem elastisch verformbaren Werkstoff, durch den eine Rückstellkraft, die entgegengesetzt zu der Betätigungskraft 3 wirkt, entsteht und durch die die Baueinheit 9 in ihrer Ausgangslage zurückgedrückt oder zurückgeführt ist, sobald die Betätigungskraft 3 wegfällt.

Im Inneren des dreidimensional ausgestalteten Schirms 22 können Dichtungselemente 26 vorgesehen sein, die das elektrische Feld nicht beeinflussen, da diese keine elektrische oder magnetische Wirkung aufweisen.

Das elektrische Feld 23 weist somit je nach Abstand des Sensors 21 und des Schirmes 22 eine unterschiedliche Charakteristik auf.

Auch der Sensor 21, die Dichtung 15 und der Schirm 22 bilden eine vorgefertigte Baueinheit 25, um die Montage zu erleichtern.

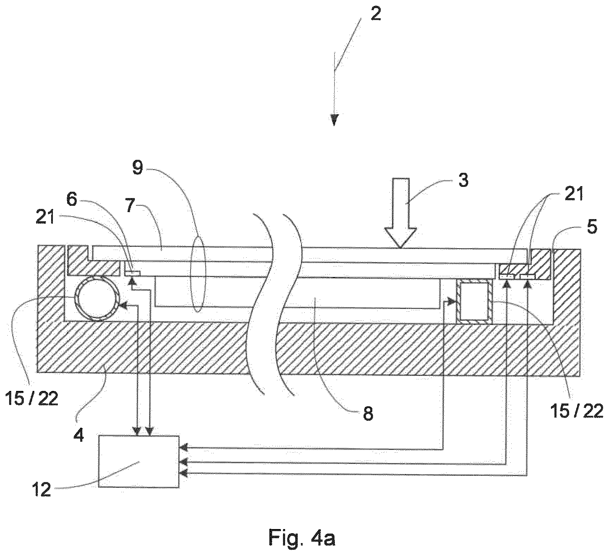

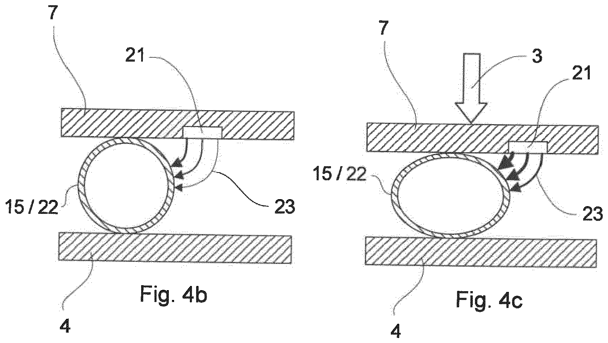

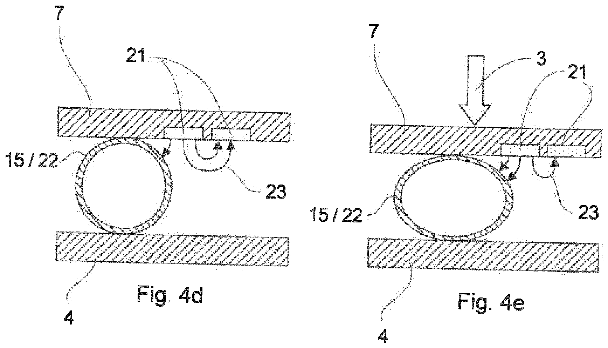

In den Figuren 4a, 4b, 4c, 4d sowie 4e sind ein fünftes und sechstes Ausführungsbeispiel der Schalt-Vorrichtung 1 zu entnehmen. Dabei ist die Baueinheit aus dem Sensor 21, der Dichtung 15 und dem Schirm 22 derart gestaltet, dass der Schirm 22 und die Dichtung 15 einteilig ausgeführt sind. Folglich dient die Dichtung 15 nicht nur dazu, das Innere des Gehäuses 4 nach außen abzudichten und eine Rückstellkraft zu erzeugen, die der Betätigungskraft 2 entgegenwirkt, sondern vielmehr beeinflusst die Dichtung 15 das elektrische Feld 23 das von dem Sensor 21 erzeugt ist, da die Dichtung 15 an der Auswertelektronik 12 angeschlossen und aus einem elektrisch leitfähigen Werkstoff hergestellt ist. Somit ist die Dichtung 15 als Schirm 22 zu verstehen und wird nachfolgend als Dichtungs-Schirm 15/22 bezeichnet. Demnach beeinflusst der Dichtungs-Schirm 15/22 des elektrischen Feld 23 das von dem jeweiligen Sensor 21 erzeugt ist, und ist räumlich beabstandet zu dem Sensor 21 angeordnet.

Gemäß der linken Seite der Figur 4a ist der Dichtungs-Schirm 15/22 im Querschnitt rund und gemäß der linken Seite der Figur 4a rechteckförmig ausgestaltet. Zudem kann der Dichtungs-Schirm 15/22 im Inneren hohl ausgestaltet sein, wodurch dessen Biegeelastizität verbessert ist.

Beispielhaft ist in den Figuren 4b und 4b der Verlauf des elektrischen Feldes 23 im betätigten sowie unbetätigten Zustand schematisch dargestellt. Das von dem Sensor 21 abgestrahlte elektrische Feld 23 trifft im unbetätigten Zustand der Abdeckplatte 7 nach einer vorgegebenen Distanz auf die Oberfläche des Dichtungs-Schirm 15/22 und sobald die Abdeckplatte 7 betätigt ist, wird der Dichtungs-Schirm 15/22 derart zusammengedrückt, dass der Abstand zwischen dem Sensor 21 und der Oberfläche des Dichtungs-Schirm 15/22 verringert ist. Schematisch ist dies in der Figur 4c mittels kräftigeren Pfeilen dargestellt, die das elektrische Feld 23 symbolisieren. Mithilfe der Auswertelektronik 12 kann die Veränderung des elektrischen Feldes 23 zwischen dem unbetätigten und dem betätigen Zustand gemessen werden, wodurch das elektrische Schaltsignal generierbar ist.

In den Figuren 4d und 4e sind in der Abdeckplatte 7 zwei Sensoren 21 ein einer Ebene verlaufend eingesetzt, deren Funktionsweise im unbetätigten und betätigen Zustand schematisch mittels Pfeilen symbolhaft abgebildet ist. Dabei ist der dem Dichtungs-Schirm 15/22 benachbarte Sensor 21 bestromt, so dass das elektrische Feld 23 teilweise in Richtung des Dichtungs-Schirmes 15/22 und zum größeren Teil zu dem benachbarten Sensor 21 abgestrahlte ist. Sobald die Abdeckplatte 7 betätigt und demnach der Dichtungs-Schirm 15/22 zusammengedrückt ist, verändert sich der Abstand zwischen dem Dichtungs-Schirm 15/22 und dem dazu benachbarten Sensor 21 derart, dass nunmehr ein größerer Anteil des elektrischen Feldes 23 zwischen dem bestromten Sensor 21 und dem Dichtungs-Schirm 15/22 verläuft und ein geringerer Anteil zwischen dem ersten und dem zweiten Sensor 21.

Durch die Auswertelektronik 12 kann diese Veränderung des elektrischen Feldes 23 gemessen und in ein elektrisches Schaltsignal umgewandelt werden.

## Patentansprüche

1. Kapazitive Schalt-Vorrichtung (1) zur Umwandlung einer manuellen oder mechanischen Zustellbewegung (2) in ein elektrisches Schaltsignal, durch das ein elektrisches Gerät gesteuert ist,
bestehend aus:
- einem Gehäuse (4), in das eine Aufnahmeöffnung (5) eingearbeitet ist,
- einem in der Aufnahmeöffnung (5) des Gehäuses (4) angeordneten Touchscreen (6), der nach außen von einer elektrisch isolierend wirkenden Abdeckplatte (7) und nach innen von einem Display (8) umschlossen ist,
- wobei die Abdeckplatte (7), der Touchscreen (6) und das Display (8) eine Baueinheit (9) bilden, die in der Aufnahmeöffnung (5) des Gehäuses (4) axial beweglich gelagert ist,
- wobei der Touchscreen (6) und das Display (8) mindestens eine kapazitiv betriebene Schaltfläche (10) aufweisen, welche bei einer Berührung eines menschlichen Fingers oder eines mechanischen Zustellgliedes geschaltet wird,
- und aus einer mit der jeweiligen Schaltfläche (10) elektrisch gekoppelten Auswerteelektronik (12), durch die bei der Berührung der jeweiligen Schaltfläche (10) ein entsprechendes Schaltsignal generiert ist
- wobei zwischen dem Gehäuse (4) und der Abdeckplatte (7) ein kapazitiv betriebener Sensor (21) vorgesehen ist,
- wobei zwischen dem Sensor (21) und der Abdeckplatte (7) ein Schirm (22) aus einem elektrisch leitfähigen Werkstoff angeordnet ist, durch den der Sensor (21) nach außen kapazitiv isoliert ist und der mit dem Sensor (21) ein gemeinsames elektrisches Feld (23) erzeugt, derart, dass bei einer Betätigung der Abdeckplatte (7) der Abstand zwischen dem Sensor (21) und dem Schirm (22) verringert ist, und dass diese Abstandsverringerung das elektrische Feld (23) beeinflusst,
- und wobei zwischen dem Gehäuse (4) und der Abdeckplatte (7) eine Dichtung (15) vorgesehen ist, durch die eine der Bewegungsrichtung (2) der Betätigungskraft (3) entgegengesetzt wirkende Rückstellkraft erzeugt ist und die aus einem elektrisch nicht-leitfähigen Werkstoff besteht, **dadurch gekennzeichnet, dass** der Sensor (21) in der Dichtung (15) angebracht ist und dass der Sensor (21) von dem Schirm (22) ganz ummantelt ist.

2. Schalt-Vorrichtung nach Anspruch 1,
**dadurch gekennzeichnet,**
**dass** der Schirm (22) und die Dichtung (15) eine gemeinsame Baueinheit (25) bilden und dass der Sensor (21) im Inneren der Baueinheit (25) relativ beweglich zu dem Gehäuse (4) angeordnet ist.

3. Schalt-Vorrichtung nach einem der Ansprüche 1 oder 2,
**dadurch gekennzeichnet,**
**dass** der Schirm (22) während der Zustellbewegung der Baueinheit (9) aus Abdeckplatte (7), Touchscreen (6) und Display (8) elastisch verformbar ist.

## Claims

1. Capacitive switching device (1) for converting a manual or mechanical feed movement (2) into an electrical switching signal by means of which an electrical device is controlled, consisting of:
- a housing (4) in which a receiving opening (5) is worked,
- a touchscreen (6) arranged in the receiving opening (5) of the housing (4), this touchscreen (6) being enclosed on the outside by an electrically insulating cover plate (7) and on the inside by a display (8),
- in which case the cover plate (7), the touchscreen (6) and the display (8) form a structural unit (9) which is mounted in the receiving opening (5) of the housing (4) so as to be axially movable,
- in which case the touchscreen (6) and the display (8) have at least one capacitively operated button (10) which is switched when touched by a human finger or a mechanical actuator,
- and of evaluation electronics (12) which are electrically coupled to the respective button (10) and by means of which a corresponding switching signal is generated when the respective button (10) is touched,
- in which case a capacitively operated sensor (21) is provided between the housing (4) and the cover plate (7),
- in which case a screen (22) made of an electrically conductive material is arranged between the sensor (21) and the cover plate (7), by means of which screen (22) the sensor (21) is capacitively insulated from the outside and which screen (22) generates a common electric field (23) with the sensor (21) in such a way that, when the cover plate (7) is actuated, the distance between the sensor (21) and the screen (22) is reduced, and in that this reduction in distance influences the electric field (23),
- and in which case a seal (15) is provided between the housing (4) and the cover plate (7), by means of which seal (15) a restoring force acting in the opposite direction to the direction of movement (2) of the actuating force (3) is generated and which seal (15) consists of an electrically non-conductive material,
**characterised in that**,
the sensor (21) is mounted in the seal (15) and that the sensor (21) is completely surrounded by the screen (22).

2. The switching device according to Claim 1,
**characterised in that**,
the screen (22) and the seal (15) form a common structural unit (25), and **in that** the sensor (21) is arranged inside the structural unit (25) such that it can move relative to the housing (4).

3. The switching device according to one of Claims 1 or 2,
**characterised in that**,
the screen (22) is elastically deformable during the feed movement of the structural unit (9) comprising the cover plate (7), touchscreen (6) and display (8).

## Revendications

1. Dispositif de commutation capacitif (1) servant à la transformation d'un mouvement d'avance manuel ou mécanique (2) en un signal de commutation électrique par lequel il est actionné un appareil électrique, comprenant :
- un boîtier (4) dans lequel il est pratiqué une ouverture de réception (5),
- un écran tactile (6) disposé dans l'ouverturee de réception (5) du boîtier (4), qui est enveloppé vers l'extérieur par un plaque de recouvrement (7) à isolement électrique et vers l'intérieur par un affichage (8),
- la plaque de recouvrement (7), l'écran tactile (6) et l'affichage (8) formant une unité (9) logée de manière axialement mobile dans l'ouverture de réception (5) du boîtier (4),
- l'écran tactile (6) et l'affichage (8) possédant au moins un bouton de commande capacitif (10) actionné par le contact d'un doigt humain ou par un élément d'avance mécanique,
- et avec un système électronique d'évaluation (12) raccordé électriquement au bouton de commande respectif (10) qui, au contact avec le bouton de commande respectif (10), génère un signal de commutation correspondant,
- où il est prévu un capteur capacitif (21) entre le boîtier (4) et la plaque de recouvrement (7),
- où, entre le capteur (21) et la plaque de recouvrement (7), il est disposé un écran (22) en matériau conducteur d'électricité qui a pour effet que le capteur (21) possède un isolement capacitif vers l'extérieur et qui, en collaboration avec le capteur (21), génère un champ électrique commun (23), de sorte qu'à l'actionnement de la plaque de recouvrement (7), il est réduit l'écartement entre le capteur (21) et l'écran (22) et que cette réduction de l'écartement influe sur le champ électrique (23),
- et où, entre le boîtier (4) et la plaque de recouvrement (7), il est prévu un joint (15) qui crée une force de rappel s'opposant au sens de mouvement (2) de la force d'actionnement (3) et qui consiste en un matériau non conducteur d'électricité,
**caractérisé en ce que**
le capteur (21) est monté dans le joint (15) et que le capteur (21) est enveloppé entièrement par l'écran (22).

2. Dispositif de commutation d'après la revendication 1,
**caractérisé en ce que**
l'écran (22) et le joint (15) constituent une unité commune (25) et qu'à l'intérieur de l'unité (25), le capteur (21) se laisse déplacer relativement au boîtier (4).

3. Dispositif de commutation d'après une des revendications 1 ou 2,
**caractérisé en ce que**
lors du mouvement d'avance de l'unité (9) formé par la plaque de recouvrement (7), l'écran tactile (6) et l'affichage (8), l'écran (22) est élastiquement déformable.
